# EUROPEAN PATENT SPECIFICATION

(11) **EP 0 851 575 B1**
(45) Date of publication and mention of the grant of the patent: **25.02.2004**
(21) Application number: 97310546.3
(22) Date of filing: 23.12.1997
(51) Int. Cl.: H03F 1/32

(54) **Radio-frequency amplifiers**
Rundfunkfrequenzverstärker
Amplicateurs de radiofréquences

(30) Priority: 24.12.1996 GB 9626930
(43) Date of publication of application: 01.07.1998
(73) Proprietor: BRITISH BROADCASTING CORPORATION, London W1A 1AA (GB)
(72) Inventor: Moss, Peter Neil, c/o British Broadcasting Corp., Tadworth, Surrey, KT206NP (GB)
(74) Representative: Abnett, Richard Charles

(56) References cited:
- EP-A- 0 423 666
- US-A- 4 462 001
- US-A- 4 465 980
- US-A- 5 327 101
- US-A- 5 574 992

## Description

### Background of the Invention

This invention relates to radio-frequency amplifiers, and particularly to a radio frequency amplifier of the type which is linearised using a feedback method.

Radio-frequency (RF) amplifiers are used for broadcasting purposes to generate transmission signals for audio and television broadcasting purposes, as well as for other radio-frequency applications. It is desirable for fidelity of transmission and to reduce undesired interfering transmissions that the amplifier should be linear, that is that the output signal should have an amplitude which varies with the amplitude of the input signal in a linear manner, and that no phase distortion should be introduced.

To improve this linearity of output signal relative to the input signal it is known to linearise the amplifier. This may be done by any of several known techniques, using for instance a feedback loop. Two known feedback methods are the Cartesian loop and polar loop methods for example. Using such loops results in a more linear amplifier.

However, the linearity is only obtained for input signal levels up to a certain point. Beyond this point, a sudden overload can occur, resulting, in general, in significant amplitude and phase distortion of the envelope of the signal passing through the amplifier.

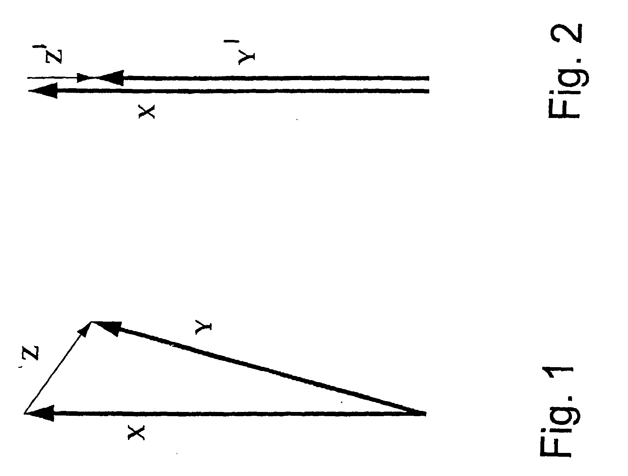

Referring to Figure 1 of the accompanying drawings, which is an amplitude phase vector diagram, it is assumed that an input signal with given amplitude and phase is intended to produce an output vector X. If the input signal is such as to exceed the limit point of the linearity of the amplifier, then the output signal obtained is not the vector X, but rather is a vector Y. The vector X is not produced because of the amplitude and phase distortion introduced by the amplifier, once the linear part of its response has been exceeded. The total error in amplitude and phase is represented by the vector Z. This is a significant error.

US-A-5327101 discloses a distortion limiter for limiting the amount of distortion of an inverting amplifier. A comparator produces a pulse when a signal level at an inverting input of the inverting amplifier exceeds a reference voltage level. The pulse charges a capacitor. When the charge on the capacitor is sufficient to raise the gate voltage of a junction field-effect transistor (FET) above cutoff, the FET shunts the input signal to reduce its level. The distortion characteristics can be controlled by using a voltage divider to adjust the voltage across the FET. A bias voltage at the gate of the FET, keeps the FET turned off when the inverting amplifier is not clipping.

US-A-4462001 discloses apparatus for linearising the transfer characteristics of a high power amplifier by predistoring the signal prior to its modulation.

A baseband lineariser includes an amplitude attenuator that receives the baseband signal and attenuates its amplitude as a function of the high power amplifier transfer characteristic, and a phase rotating circuit that receives the attenuated baseband signal and rotates its phase angle as a function of the high power amplifier transfer characteristic. The baseband lineariser may further include a detector for determining the power level of the baseband signal in order to control the attenuator and the phase rotating circuit.

### Summary of the Invention

The present invention is defined in Claim 1 below to which reference should now be made. Advantageous features are set forth in the appendant claims. Preferred embodiments of the invention are described in more detail below with reference to the drawings.

The present inventor has appreciated that there may be situations in which it is desired to allow the signal to cross into the nonlinear region for a certain proportion of the time, and in these situations the signal distortion can be reduced by pre-clipping the input signal envelope prior to its application by the amplifier.

In the preferred embodiments described below, the signal distortion is reduced by precisely pre-clipping the input signal envelope to a point just below where the sudden overload occurs within the amplifier. The result of this deliberate introduction of clipping, which would normally be regarded as undesirable, is to substantially reduce the phase distortion.

### Brief Description of the Drawings

The invention will be described in more detail by way of example with reference to the drawings, in which:
**Figure 1** (described above) illustrates on a vector diagram the vector error introduced in a known RF amplifier using a feedback linearisation method when operated above its linear region;
**Figure 2** illustrates a corresponding vector diagram for an amplifier embodying the invention;
**Figure 3** is a block circuit diagram for an analogue amplifier modified in accordance with the invention; and
**Figure 4** is a block circuit diagram for a digital amplifier modified in accordance with the invention.

### Detailed description of the Preferred Embodiments

Figure 2 is an amplitude-phase vector diagram, corresponding to Figure 1, for an amplifier using a pre-clipping method in accordance with the invention. The output vector is reduced to a new value Y' by the pre-clipping operation. The total error Z' is now considerably less than the previous error Z, leading to less signal distortion.

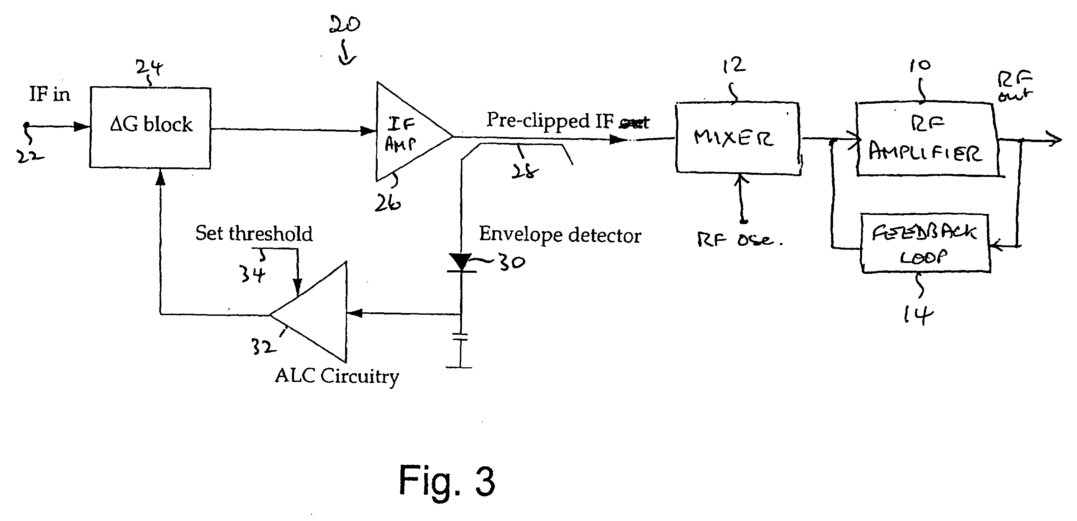

A first embodiment of the invention, which operates with analogue signals, is shown in Figure 3. The RF amplifier 10 receives the output of a mixer 12 which combines an IF (intermediate frequency) signal with a signal from an RF oscillator, in well-known manner. The amplifier is linearised by a feedback loop 14 shown diagrammatically in the figure. The RF amplifier is preceded by a clipper or pre-processing circuit 20 which clips the magnitude of the IF input signal to the mixer at a predetermined limit value which is chosen to be at the top end of the linear range of the amplifier 10.

The clipper circuit 20 has an input 22 for receiving the IF signal input, to which is connected a variable-gain circuit 24. The output of the variable-gain circuit, or variable-gain block, is applied to the main IF amplifier circuit 26. The output of the IF amplifier circuit 26 is applied to the mixer 12. A portion of the IF amplifier circuit output is fed away as shown at 28 and applied to an envelope detector 30, illustratively shown as a diode. The output of the envelope detector 30 is applied to a fast-acting automatic level control (ALC) circuit 32, the output of which is applied to a control input of the variable-gain circuit 24. The automatic level control circuit 32 compares the output of the envelope detector 30 with a threshold applied at 34. The ALC circuit 32 thus acts only if the signal exceeds a predetermined threshold, but if the signal exceeds the threshold by only a very small degree, the ALC circuit rapidly reduces the signal gain so as to prevent the signal rising further. In this way the maximum value of the envelope is limited. The variable gain circuit 24 reacts sufficiently quickly to the output of the ALC circuit 32 so as to influence the instantaneous signal level, and not just the average signal level.

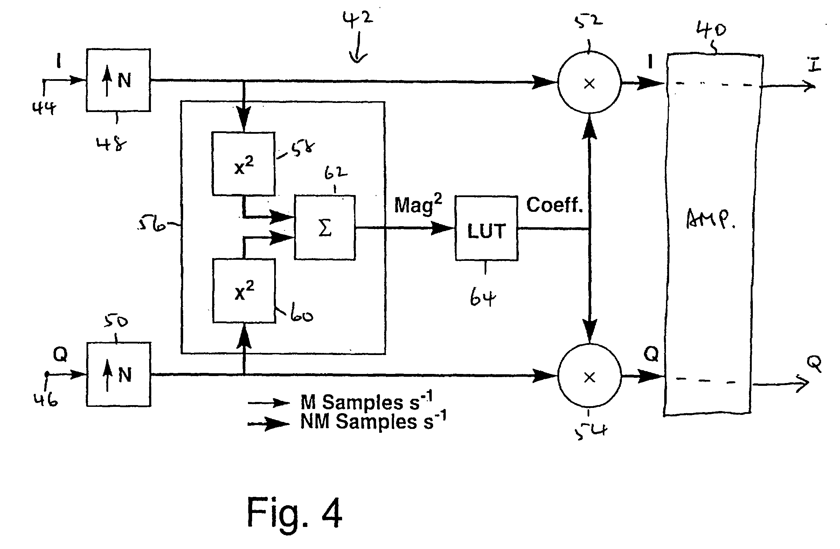

Figure 4 illustrates a second embodiment of the invention, designed for use with digital signals. In this case there are, as is well known, two signals I and Q which carry the in-phase and quadrature complex signal components. Thus there are two parallel signal channels through the amplifier 40, shown diagrammatically. The amplifier 40 has a linearisation circuit (not shown) associated with it. The pre-clipper 42 has two inputs 44,46 for receiving the I and Q signals respectively. The input signals have a sampling rate of M samples per second, and are first applied to up-samplers 48, 50 which increase the sampling rate by a factor N. Typically N may be 2 or 4. The up-sampling ensures that accurate pre-clipping can take place.

The outputs of the up-samplers are applied to a respective one of two multiplicative amplifiers 52,54 and also to a computation circuit 56. In the computation circuit 46, two squarers 58,60 provide the squares of the values of the I and Q signals, and a combining circuit in the form of an adder 62 receives the outputs of the squares and adds them together. Thus the adder 62 which constitutes the output of the computation circuit 56 provides an output representative of the sum of the squares of the complex input signal components, viz: (I² + Q²).

The computed value of the magnitude obtained in this way in the computation circuit 56, which represents the square of the magnitude, is then applied to a look-up table (LUT) 64 in the form of a read-only memory (ROM). The output of the LUT 64 is applied to the other input of each of the multipliers 52, 54 as a multiplying coefficient.

The look-up table 64 provides fixed coefficients to the multipliers 52, 54 over the linear range of the amplifier 40. Above the linear range, the coefficients are reduced so as to limit the magnitude of the complex output to a predetermined maximum, that is the maximum linear output from the amplifier 40. The required values for the look-up table can be calculated from the circuit parameters or can be found empirically. The operation is such that if the computed value exceeds a predetermined threshold, then the values of I and Q output from the pre-clipper 42 are scaled down by the same degree. Thus the maximum value of the signal envelope is limited.

The signal applied to the look-up table 64 represents the square of the signal magnitude. It would be possible to take the square root of this, but there is no point, as the look-up table can be constructed so as to allow for this automatically. In principle, the look-up table could receive the outputs of the up-samplers 48, 50 directly and could also implement the computation achieved by computation circuit 56, but in this case an impracticably large look-up table might be required.

Various other modifications may be made to the circuits described. For example, whereas the clipping in the analogue circuit of Figure 3 has been described as operating at IF frequency it could operate at RF frequency itself, or at baseband. The digital implementation may be achieved in software rather than in hardware, in which case Figure 4 should be regarded as a flow chart rather than as a hardware block diagram.

## Claims

1. A radio-frequency amplifier circuit, comprising:
a radio frequency amplifier (10, 40) for receiving an input signal at its input and providing an amplified output signal at its output, and having a linearisation circuit (14) to substantially linearise the amplifier over a linear operating range; and
a pre-processing circuit (20, 42) separate from the linearistaion circuit (14) the output of which is coupled to the input of the radio-frequency amplifier and which includes clipping circuit operative to clip the magnitude of the input signal substantially to a predetermined value just below the top of the linear operating range of the radio-frequency amplifier.

2. A radio-frequency amplifier circuit according to claim 1, in which the linearisation circuit comprises a feedback circuit.

3. A radio-frequency amplifier circuit according to claim 2, in which the feedback circuit is a Cartesian or polar loop circuit.

4. A radio-frequency amplifier circuit according to claim1, 2 or 3, in which the preprocessing circuit is effective to reduce the phase distortion in the output of the radio-frequency amplifier.

5. A radio-frequency amplifier circuit according to any of claims 1 to 4, in which the amplifier operates with analogue signals.

6. A radio-frequency amplifier circuit according to claim 5, including a mixer circuit (12) coupled between the pre-processing circuit and the radio-frequency amplifier, and in which the pre-processing circuit operates at an intermediate frequency (IF).

7. A radio-frequency amplifier circuit according to claim 5 or 6, in which the pre-processing circuit comprises a variable-gain amplifier (24, 26) in the signal path, and an automatic level control circuit (30, 32, 34) responsive to the signal applied to the radio-frequency amplifier to compare the signal with a threshold (34) and provide a control signal for the variable-gain amplifier in dependence thereon.

8. A radio-frequency amplifier circuit according to claim 5, 6 or 7, in which the automatic level control circuit is a fast-acting circuit (32), and the variable-gain circuit acts sufficiently quickly to influence the instantaneous signal level.

9. A radio-frequency amplifier circuit according to any of claims 1 to 4, in which the amplifier operates with digital signals.

10. A radio-frequency amplifier circuit according to claim 9, in which the pre-processing circuit (56) is operative to calculate the sum of the squares of the in-phase and quadrature components of the digital signal.

11. A radio-frequency amplifier circuit according to claim 9 or 10, including up-sampling means (48, 50) coupled to the input of the pre-processing circuit to increase the sampling rate of the components of the input signal.

12. A radio-frequency amplifier circuit according to claim 9, 10 or 11, in which the pre-processing circuit includes amplifiers (52, 54) for the in-phase and quadrature components of the input signal, and look-up table means (64) the output of which controls the amplifiers in the pre-processing circuit.

13. A method of radio frequency amplification, comprising the steps of:
providing a radio frequency amplifier (10,40);
substantially linearising the amplifier over a linear operating range thereof;
clipping the magnitude of an input signal substantially to a predetermined value just below the top of the linear operating range of the radio frequency amplifier before applying it to the radio frequency amplifier;
receiving the clipped input signal at the input of the amplifier; and
providing an amplified signal at the output of the radio frequency amplifier,
wherein the linearising and clipping steps are separated.

14. A method of substantially avoiding the effects of phase distortion in a radio-frequency signal, comprising amplifying the radio-frequency signal in accordance with the method of claim 13.

## Patentansprüche

1. Radiofrequenzverstärkerschaltung, umfassend:
einen Radiofrequenzverstärker (10, 40) zum Empfangen eines Eingangssignals an seinem Eingang und zum Bereitstellen eines verstärkten Ausgangssignals an seinem Ausgang und mit einer Linearisierungsschaltung (14), um den Verstärker über einen Linearbetriebsbereich im Wesentlichen zu linearisieren; und
eine von der Linearisierungsschaltung (14) separate Vorverarbeitungsschaltung (20, 42), deren Ausgang mit dem Eingang des Radiofrequenzverstärkers gekoppelt ist und die eine Begrenzerschaltung hat, die die Aufgabe hat, die Größe des Eingangssignals im Wesentlichen auf einen vorbestimmten Wert knapp unter dem oberen Ende des Linearbetriebsbereichs des Radiofrequenzverstärkers zu begrenzen.

2. Radiofrequenzverstärkerschaltung nach Anspruch 1, bei der die Linearisierungsschaltung eine Rückkopplungsschaltung umfasst.

3. Radiofrequenzverstärkerschaltung nach Anspruch 2, bei der die Rückkopplungsschaltung eine kartesische oder polare Schleifenschaltung ist.

4. Radiofrequenzverstärkerschaltung nach Anspruch 1, 2 oder 3, bei der die Vorverarbeitungsschaltung wirkt, um die Phasenverzerrung im Ausgang des Radiofrequenzverstärkers zu reduzieren.

5. Radiofrequenzverstärkerschaltung nach einem der Ansprüche 1 bis 4, bei der der Verstärker mit analogen Signalen arbeitet.

6. Radiofrequenzverstärkerschaltung nach Anspruch 5, der eine Mischerschaltung (12) hat, die zwischen der Vorverarbeitungsschaltung und dem Radiofrequenzverstärker eingekoppelt ist und bei der die Vorverarbeitungsschaltung auf Zwischenfrequenz (ZF) arbeitet.

7. Radiofrequenzverstärkerschaltung nach Anspruch 5 oder 6, bei der die Vorverarbeitungsschaltung einen einstellbaren Verstärker (24, 26) im Signalweg und eine automatische Pegelregelungsschaltung (30, 32, 34) aufweist, die auf das an den Radiofrequenzverstärker angelegte Signal reagiert, um das Signal mit einer Schwelle (34) zu vergleichen und in Abhängigkeit davon ein Steuersignal für den einstellbaren Verstärker sendet.

8. Radiofrequenzverstärkerschaltung nach Anspruch 5, 6 oder 7, bei der die automatische Pegelregelungsschaltung eine schnell wirkende Schaltung (32) ist und die einstellbare Schaltung schnell genug reagiert, um den Momentansignalpegel zu beeinflussen.

9. Radiofrequenzverstärkerschaltung nach einem der Ansprüche 1 bis 4, bei der der Verstärker mit digitalen Signalen arbeitet.

10. Radiofrequenzverstärkerschaltung nach Anspruch 9, bei der die Vorverarbeitungsschaltung (56) die Aufgabe hat, die Summe der Quadrate der phasengleichen und Quadraturkomponenten des digitalen Signals zu berechnen.

11. Radiofrequenzverstärkerschaltung nach Anspruch 9 oder 10 mit Mitteln für höhere Abtastung (48, 50), die mit dem Eingang der Vorverarbeitungsschaltung gekoppelt sind, um die Abtastfrequenz der Komponenten des Eingangssignals zu erhöhen.

12. Radiofrequenzverstärkerschaltung nach Anspruch 9,10 oder 11, bei der die Vorverarbeitungsschaltung Verstärker (52, 54) für die phasengleichen und Quadraturkomponenten des Eingangssignals und Nachschlagtabellen (64) hat, deren Ausgang die Verstärker in der Vorverarbeitungsschaltung steuert.

13. Verfahren zur Radiofrequenzverstärkung, umfassend die folgenden Schritte:
Bereitstellen eines Radiofrequenzverstärkers (10, 40),
im Wesentlichen Linearisieren des Verstärkers über einen Linearbetriebsbereich davon,
Begrenzen der Größe eines Eingangssignals im Wesentlichen auf einen vorbestimmten Wert knapp unter dem oberen Ende des Linearbetriebsbereichs des Radiofrequenzverstärkers, bevor es an den Radiofrequenzverstärker angelegt wird,
Empfangen des begrenzten Eingangssignals am Eingang des Verstärkers und
Bereitstellen eines verstärkten Signals am Ausgang des Radiofrequenzverstärkers,
wobei die Linearisierungs- und Begrenzungsschritte getrennt sind.

14. Verfahren zum im Wesentlichen Vermeiden der Phasenverzerrungseffekte in einem Radiofrequenzsignal, das die Verstärkung des Radiofrequenzsignals gemäß dem Verfahren von Anspruch 13 umfasst.

## Revendications

1. Circuit amplificateur de fréquences radioélectriques, comprenant :
un amplificateur de fréquences radioélectriques (10, 40) pour recevoir un signal d'entrée à son entrée et fournir un signal de sortie amplifié à sa sortie, et ayant un circuit de linéarisation (14) pour sensiblement linéariser l'amplificateur sur une gamme opérationnelle linéaire ; et
un circuit de prétraitement (20, 42) séparé du circuit de linéarisation (14) dont la sortie est couplée à l'entrée de l'amplificateur de fréquences radioélectriques et qui comporte un circuit d'écrêtage servant à écrêter la grandeur du signal d'entrée sensiblement à une valeur prédéterminée juste en dessous du haut de la gamme opérationnelle linéaire de l'amplificateur de fréquences radioélectriques.

2. Circuit amplificateur de fréquences radioélectriques selon la revendication 1, dans lequel le circuit de linéarisation comprend un circuit de contre-réaction.

3. Circuit amplificateur de fréquences radioélectriques selon la revendication 2, dans lequel le circuit de contre-réaction est un circuit de boucle cartésienne ou polaire.

4. Circuit amplificateur de fréquences radioélectriques selon la revendication 1, 2 ou 3, dans lequel le circuit de prétraitement sert à réduire la distorsion de phase dans la sortie de l'amplificateur de fréquences radioélectriques.

5. Circuit amplificateur de fréquences radioélectriques selon l'une quelconque des revendications 1 à 4, dans lequel l'amplificateur fonctionne avec des signaux analogiques.

6. Circuit amplificateur de fréquences radioélectriques selon la revendication 5, comportant un circuit de mélangeur (12) couplé entre le circuit de prétraitement et l'amplificateur de fréquences radioélectriques, et dans lequel le circuit de prétraitement fonctionne à une fréquence intermédiaire (FI).

7. Circuit amplificateur de fréquences radioélectriques selon la revendication 5 ou 6, dans lequel le circuit de prétraitement comprend un amplificateur à gain variable (24, 26) dans le trajet de signal, et un circuit de commande de niveau automatique (30, 32, 34) sensible au signal appliqué à l'amplificateur de fréquences radioélectriques afin de comparer le signal à un seuil (34) et fournir un signal de commande de l'amplificateur à gain variable en fonction de cette comparaison.

8. Circuit amplificateur de fréquences radioélectriques selon la revendication 5, 6 ou 7, dans lequel le circuit de commande de niveau automatique est un circuit à action rapide (32) et le circuit à gain variable agit suffisamment rapidement pour influencer le niveau de signal instantané.

9. Circuit amplificateur de fréquences radioélectriques selon l'une quelconque des revendications 1 à 4, dans lequel l'amplificateur fonctionne avec des signaux numériques.

10. Circuit amplificateur de fréquences radioélectriques selon la revendication 9, dans lequel le circuit de prétraitement (56) fonctionne pour calculer la somme des carrés des composantes en phase et en quadrature du signal numérique.

11. Circuit amplificateur de fréquences radioélectriques selon la revendication 9 ou 10, comportant un moyen de suréchantillonnage (48, 50) couplé à l'entrée du circuit de prétraitement afin d'augmenter la cadence d'échantillonnage des composantes du signal d'entrée.

12. Circuit amplificateur de fréquences radioélectriques selon la revendication 9, 10 ou 11, dans lequel le circuit de prétraitement comporte des amplificateurs (52, 54) des composantes en phase et en quadrature du signal d'entrée, et un moyen de table de consultation (64) dont la sortie commande les amplificateurs dans le circuit de prétraitement.

13. Procédé d'amplification de fréquences radioélectriques, comprenant les étapes consistant à :
fournir un amplificateur de fréquences radioélectriques (10, 40) ;
sensiblement linéariser l'amplificateur sur une gamme opérationnelle linéaire de celui-ci ;
écrêter la grandeur d'un signal d'entrée sensiblement à une valeur prédéterminée juste en dessous du haut de la gamme opérationnelle linéaire de l'amplificateur de fréquences radioélectriques avant de l'appliquer à l'amplificateur de fréquences radioélectriques ;
recevoir le signal d'entrée écrété à l'entrée de l'amplificateur ; et
fournir un signal amplifié à la sortie de l'amplificateur de fréquences radioélectriques,
dans lequel les étapes consistant à linéariser et à écrêter sont séparées.

14. Procédé pour sensiblement éviter les effets de distorsion de phase dans un signal de fréquence radioélectrique, comprenant l'amplification du signal de fréquence radioélectrique conformément au procédé de la revendication 13.
